# EUROPEAN PATENT APPLICATION

(11) **EP 2 200 099 A1**
(43) Date of publication of application: **23.06.2010**
(21) Application number: 08833533.6
(22) Date of filing: 09.09.2008
(51) Int. Cl.: H01L 33/00

(54) **GROUP III NITRIDE SEMICONDUCTOR LIGHT-EMITTING DEVICE, METHOD FOR MANUFACTURING THE SAME, AND LAMP**

(30) Priority: 27.09.2007 JP 2007251478
(71) Applicant: Showa Denko K.K., Tokyo 105-8518 (JP)
(72) Inventor: YOKOYAMA, Yasunori, Ichihara-shi Chiba 290-0067 (JP); MIKI, Hisayuki, Ichihara-shi Chiba 290-0067 (JP)
(74) Representative: Strehl Schübel-Hopf & Partner
(86) International application number: PCT/JP2008/066261
(87) International publication number: WO 2009/041256

(57) **Abstract**

A buffer layer 12 composed of at least a Group III nitride compound is laminated on a substrate 11 composed of sapphire, and an n-type semiconductor layer 14, a light-emitting layer 15, and a p-type semiconductor layer 16 are laminated in a sequential manner on the buffer layer 12. The buffer layer 12 is formed by means of a reactive sputtering method, the buffer layer 12 contains oxygen, and the oxygen concentration in the buffer layer 12 is 1 atomic percent or lower. There are provided a Group III nitride compound semiconductor light-emitting device that comprises the buffer layer formed on the substrate by means of the reactive sputtering method, enables formation of a Group III nitride semiconductor having favorable crystallinity thereon, and has a superior light emission property, and a manufacturing method thereof, and a lamp.

## Description

### TECHNICAL FIELD

The present invention relates to a Group III nitride semiconductor light-emitting device that is suitable for use in a light-emitting diode (LED), a laser diode (LD), an electronic device, or the like and that is prepared by laminating Group III nitride semiconductors expressed in a general formula AlₐGa_{b}In_{c}N (0 ≤ a ≤ 1, 0 ≤ b ≤ 1, 0 ≤ c ≤ 1, a + b + c = 1), and to a method for manufacturing the device, and to a lamp.
The present invention claims priority on Japanese Patent Application No. 2007-251478, the contents of which are incorporated herein by reference.

### BACKGROUND ART

A Group III nitride semiconductor possess a band gap of a direction transition type of energy corresponding to the visible light through the ultraviolet light region and has an excellent level of light emission efficiency. Consequently, it has been commercialized as semiconductor light-emitting devices such as light-emitting diodes (LED), laser diodes (LD) and to be used in a variety of purposes. Also in those cases where a Group III nitride semiconductor is used in an electronic device, it has the potential to achieve superior properties compared to a case where a conventional Group III compound semiconductor is used.

Such a Group III nitride semiconductor is, in general, produced by means of a MOCVD (metal-organic chemical vapor deposition) method with materials such as trimethyl gallium, triethyl aluminum, and ammonia. In the MOCVD method, vapors of the materials contained in a carrier gas are transported to the substrate surface, and the materials are decomposed on the heated substrate surface, to thereby grow crystals.

Conventionally, single crystal wafers of Group III nitride semiconductor have not been commercially available, and Group III nitride semiconductors are commonly obtained by growing crystals on a single crystal wafer of a different material. Between such different types of substrates and Group III nitride semiconductor crystals epitaxially grown thereon, there is a considerable lattice misfit. For example, in those cases where gallium nitride (GaN) is grown on a sapphire (Al₂O₃) substrate, a 16% lattice misfit is present therebetween, and in those cases where gallium nitride is grown on a SiC substrate, a 6% lattice misfit is present therebetween. In general, there is a problem in that in those cases where there is a considerable lattice misfit as described above, it is difficult to epitaxially grow crystals directly on the substrate, and even if crystals are grown thereon, crystals with superior crystallinity cannot be obtained.

Consequently, there has been proposed and commonly practiced a method in which when epitaxially growing Group III nitride crystals on a sapphire single crystal substrate or on a SiC single crystal substrate by means of the metal-organic chemical vapor deposition (MOCVD) method, first, a layer called a low temperature buffer layer composed of aluminum nitride (AlN) or aluminum gallium nitride (AlGaN) is laminated on the substrate, and Group III nitride semiconductor crystals are epitaxially grown thereon at a high temperature (for example, refer to Patent Documents 1 and 2).

However, in the method disclosed in Patent Documents 1 and 2, a lattice misfit is present between the substrate and the Group III nitride semiconductor crystals grown thereon, and consequently dislocation called threading dislocation that extends towards the surface is contained within the grown crystals. Accordingly, there has been a problem in that distortion occurs in the crystals, sufficient light emission intensity cannot be obtained without optimizing the structure, and productivity is reduced.

Moreover, there also has been proposed a technique for forming the buffer layer by means other than the MOCVD method. For example, there is proposed a method in which on a buffer layer formed by means of high frequency sputtering, crystals of the same composition are grown by means of the MOCVD method (for example, refer to Patent Document 3). However, in the method disclosed in Patent Document 3, there is a problem in that favorable crystals cannot be laminated stably on the substrate.

Consequently, in order to stably obtain favorable crystals, there have been proposed: a method in which a buffer layer is grown first and then it is annealed in a mixed gas of ammonia and hydrogen (for example, refer to Patent Document 4); and a method in which a buffer layer is formed by means of DC sputtering at a temperature not less than 400°C (for example, refer to Patent Document 5).
Moreover, there has also be proposed a method in which an aluminum oxynitride layer having a predetermined oxygen composition ratio and nitrogen composition ratio is formed on a sapphire substrate, a buffer layer prepared with a nitride semiconductor with a p-type impurity introduced thereinto is formed on this aluminum oxynitride layer, and furthermore a nitride semiconductor thin film is formed on this buffer layer (for example, refer to Patent Document 6).
[Patent Document 1] Japanese Patent Publication No. 3026087
[Patent Document 2] Japanese Unexamined Patent Application, First Publication No. H04-297023
[Patent Document 3] Japanese Examined Patent Application, Second Publication No. H05-86646
[Patent Document 4] Japanese Patent Publication No. 3440873
[Patent Document 5] Japanese Patent Publication No. 3700492
[Patent Document 6] Japanese Unexamined Patent Application, First Publication No. 2006-4970

### DISCLOSURE OF INVENTION

### [Problems to be Solved by the Invention]

In those cases where a buffer layer is formed on a substrate with use of the sputtering methods disclosed in the above Patent Documents 3 to 6, oxygen-containing substances such as moisture attached on the chamber inner wall of a sputtering apparatus are expelled from the inner wall as a result of sputtering and get inevitably mixed when forming the buffer layer on the substrate. Consequently, the buffer layer formed by means of the sputtering method becomes a film that at least contains a certain percentage, for example, in a range of approximately 2%, of oxygen.
However, the inventors of the present invention undertook intensive investigation and discovered that if the oxygen concentration in the buffer layer exceeds, for example, 1%, the crystallinity of the Group III nitride semiconductor laminated on this buffer layer is reduced, and consequently the light emission properties of the light-emitting device prepared with the Group III nitride semiconductor is reduced in some cases.

The present invention takes the above circumstances into consideration, with an object of providing; a Group III nitride semiconductor light-emitting device that has a superior light emission property, a method for manufacturing the device, and a lamp.

### [Means for Solving the Problem]

The present invention relates to the aspects described below.
[1] A Group III nitride semiconductor light-emitting device formed such that a buffer layer composed of at least a Group III nitride compound is laminated on a substrate composed of sapphire, and an n-type semiconductor layer, a light-emitting layer, and a p-type semiconductor layer are sequentially laminated on the buffer layer, and the buffer layer is formed by means of a reactive sputtering method, the buffer layer contains oxygen, and an oxygen concentration in the buffer layer is 1 atomic percent or lower.
[2] The Group III nitride semiconductor light-emitting device according to [1], wherein the buffer layer is formed by means of a reactive sputtering method, in which a metallic Al material and a gas containing a nitrogen element are activated with plasma, and it is prepared with AlN.
[3] The Group III nitride semiconductor light-emitting device according to [1] or [2], wherein the oxygen concentration in the buffer layer is 0.8 atomic percent or lower.
[4] The Group III nitride semiconductor light-emitting device according to any one of [1] to [3], wherein the oxygen contained in the buffer layer is distributed within the buffer layer film at a substantially uniform oxygen concentration.

[5] The Group III nitride semiconductor light-emitting device according to any one of [1] to [4], wherein the film thickness of the buffer layer is within a range from 10 to 500 nm.
[6] The Group III nitride semiconductor light-emitting device according to any one of [1] to [5], wherein the film thickness of the buffer layer is within a range from 20 to 100 nm.
[7] The Group III nitride semiconductor light-emitting device according to any one of [1] to [7], wherein the buffer layer is formed so as to cover at least 90% of the substrate surface.

[8] A method for manufacturing a Group III nitride semiconductor light-emitting device in which a buffer layer composed of at least a Group III nitride compound is laminated on a substrate composed of sapphire, and an n-type semiconductor layer, a light-emitting layer, and a p-type semiconductor layer are sequentially laminated on the buffer layer, and the buffer layer is formed by means of a reactive sputtering method such that the buffer layer contains oxygen and an oxygen concentration in the buffer layer is 1 atomic percent or lower.
[9] The method for manufacturing a Group III nitride semiconductor light-emitting device according to [8], wherein the buffer layer is formed by means of a reactive sputtering method, and a metallic Al material and a gas containing a nitrogen element are activated with plasma, and it is formed with AlN.
[10] The method for manufacturing a Group III nitride semiconductor light-emitting device according to [8] or [9], wherein the buffer layer is formed under a condition where the ultimate vacuum within the chamber of a sputtering apparatus is 1.5 × 10⁻⁵ Pa or lower. [11] The method for manufacturing a Group III nitride semiconductor light-emitting device according to any one of [8] to [10], wherein the buffer layer is formed after dummy discharges have been performed within the chamber of the sputtering apparatus.

[12] The method for manufacturing a Group III nitride semiconductor light-emitting device according to any one of [8] to [11], wherein the buffer layer is formed by means of a reactive sputtering method in which the gas containing a nitrogen element is supplied within a reactor.
[13] The method for manufacturing a Group III nitride semiconductor light-emitting device according to any one of [8] to [12], wherein the buffer layer is formed by means of a RF sputtering method.
[14] The method for manufacturing a Group III nitride semiconductor light-emitting device according to any one of [8] to [13], wherein the buffer layer is formed where the temperature of the substrate is within a range from 400 to 800°C.

[15] A Group III nitride semiconductor light-emitting device obtained by the manufacturing method according to any one of [8] to [14].
[16] A lamp formed with use of the Group III nitride semiconductor light-emitting device according to any one of [1] to [7] and [15].

### [Effect of the Invention]

According to the Group III nitride semiconductor light-emitting device of the present invention, the buffer layer formed by means of a reactive sputtering method contains oxygen and the oxygen concentration in the buffer layer is 1 atomic percent or lower, and consequently the crystallinity of the Group III nitride semiconductor laminated on the buffer layer is enhanced. As a result, a Group III nitride semiconductor light-emitting device having a superior light emission property can be obtained.

### BRIEF DESCRIPTION OF THE DRAWINGS

FIG. 1 is a diagram for schematically describing an example of a Group III nitride semiconductor light-emitting device according to the present invention, and is a schematic diagram showing a cross-sectional structure of a laminated semiconductor.
FIG. 2 is a diagram for schematically describing an example of the Group III nitride semiconductor light-emitting device according to the present invention, and is a schematic diagram showing a plan view thereof.
FIG. 3 is a diagram for schematically describing an example of the Group III nitride semiconductor light-emitting device according to the present invention, and is a schematic diagram showing a cross-sectional view thereof.
FIG. 4 is a schematic diagram for schematically describing a lamp configured with use of the Group III nitride semiconductor light-emitting device according to the present invention.
FIG. 5 is a diagram for schematically describing an example of a method for manufacturing the Group III nitride semiconductor light-emitting device according to the present invention, and is a schematic diagram showing a structure of a sputtering apparatus having a target within a chamber.
FIG. 6 is a diagram for describing an embodiment of the Group III nitride semiconductor light-emitting device according to the present invention, wherein FIG. 6A and FIG. 6B are graphs showing compositions in a buffer layer.
FIG. 7 is a diagram for describing an embodiment of the method for manufacturing the Group III nitride semiconductor light-emitting device according to the present invention, wherein FIG. 7A is a graph showing a relationship between the number of dummy discharges and oxygen concentration in the buffer layer, and FIG. 7B is a graph showing a relationship between ultimate vacuum within the chamber and oxygen concentration within the buffer layer.

### [DESCRIPTION OF THE REFERENCE SYMBOLS]

- 1: Group III nitride semiconductor light-emitting device
- 10: Laminated semiconductor
- 11: Substrate
- 11a: Surface
- 12: Buffer layer
- 14: n-type semiconductor layer
- 14a: Base layer
- 15: Light-emitting layer
- 16: p-type semiconductor layer (Group III nitride semiconductor)
- 16a: p-type cladding layer
- 16b: p-type contact layer
- 3: Lamp
- 40: Sputtering apparatus
- 41: Chamber

### BEST MODE FOR CARRYING OUT THE INVENTION

Hereunder, there is described, with appropriate reference to the accompanying drawings, an embodiment of a Group III nitride semiconductor light-emitting device, a manufacturing method thereof, and a lamp according to the present invention.

### [Group III nitride semiconductor light-emitting device]

The Group III nitride semiconductor light-emitting device (hereunder also abbreviated as a "light-emitting device") 1 of the present embodiment is a semiconductor light-emitting device 1 comprising, on a sapphire substrate 11, a buffer layer 12 composed of at least a Group III nitride compound is formed, and an n-type semiconductor layer 14, a light-emitting layer 15, and a p-type semiconductor layer 16 are stacked sequentially on the buffer layer 12. The buffer layer 12 is formed by means of a reactive sputtering method, the buffer layer 12 contains oxygen, and the oxygen concentration in the buffer layer 12 is 1 atomic percent or lower.

### <Laminated Structure of Light-Emitting Device>

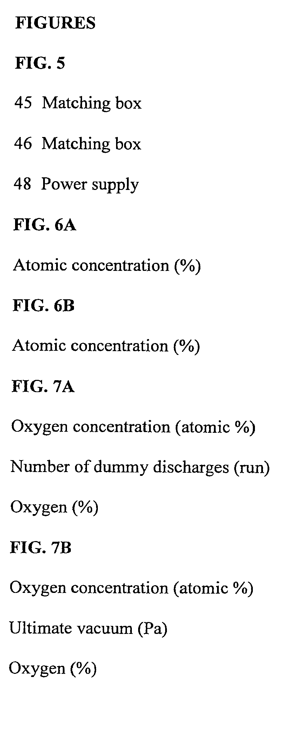

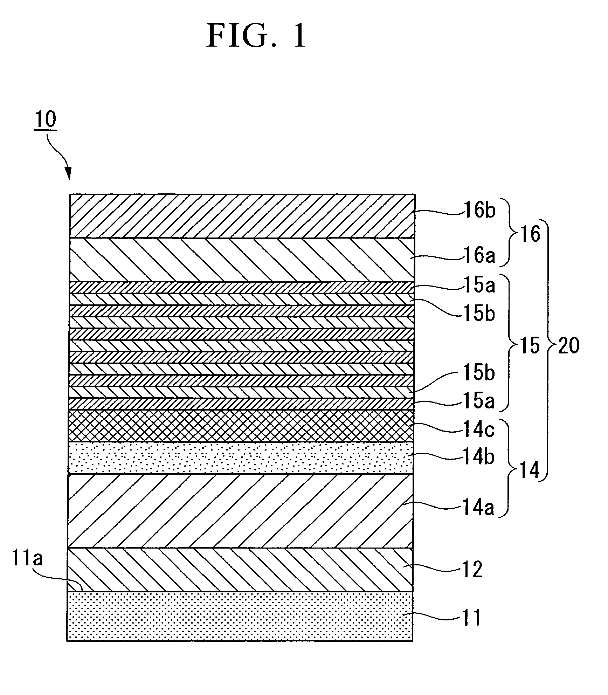

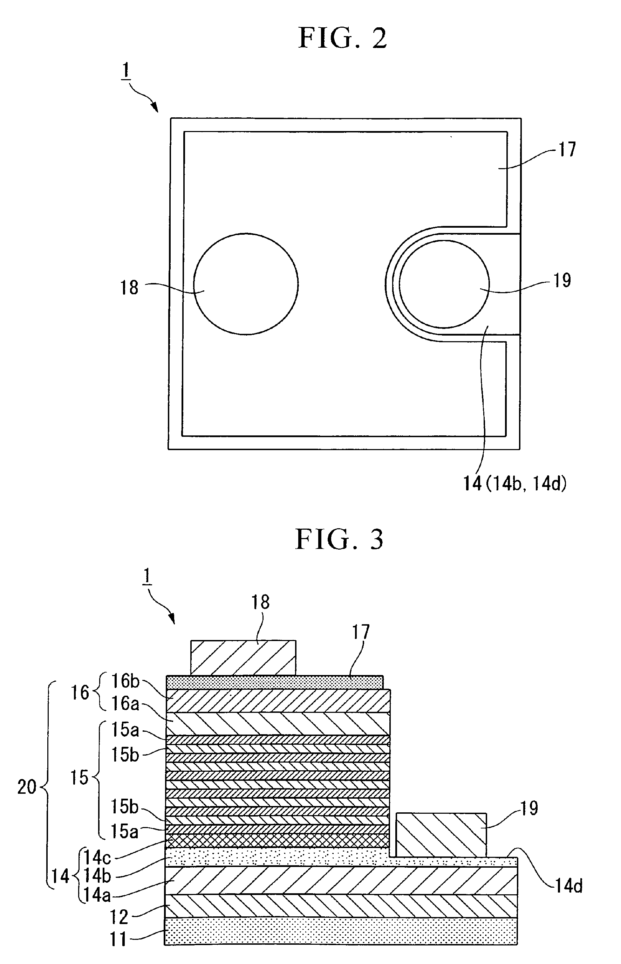

FIG. 1 is a diagram for describing an example of the Group III nitride semiconductor light-emitting device according to the present invention, and is a schematic sectional view showing an example of a laminated semiconductor in which a Group III nitride semiconductor is formed on a substrate.
A laminated semiconductor 10 shown in FIG. 1 is such that the buffer layer 12 composed of the Group III nitride compound is laminated on the substrate 11, and on the buffer layer 12, there is formed a semiconductor layer 20 having the n-type semiconductor layer 14, the light-emitting layer 15, and a p-type semiconductor layer 16 laminated in a sequential manner. The buffer layer 12 of the present embodiment is a layer that is formed by means of a reactive sputtering method, and the oxygen concentration thereof is 1 atomic percent or lower.
On the abovementioned laminated semiconductor 10, as shown with the example illustrated in the plan view of FIG. 2 and the sectional view of FIG. 3, a translucent positive electrode 17 is laminated on the p-type semiconductor layer 16, a positive electrode bonding pad 18 is formed thereon, and a negative electrode 19 is laminated on an exposed region 14d formed a n-type contact layer 14b of the n-type semiconductor layer 14, to thereby configure the light-emitting device 1 of the present embodiment.
Hereunder, there is described in detail of a laminated structure of the Group III nitride semiconductor light-emitting device of the present embodiment.

### "Substrate"

In the present embodiment, sapphire is used for the material of the substrate 11.
In general, as the material to be used for the substrate on which the Group III nitride semiconductor crystals are laminated, there may be selected for use any of substrate materials, on the surface of which Group III nitride semiconductor crystals are able to undergo epitaxial growth, such as sapphire, SiC, silicon, zinc oxide, magnesium oxide, manganese oxide, zirconium oxide, manganese zinc iron oxide, magnesium aluminum oxide, zirconium boride, gallium oxide, indium oxide, lithium gallium oxide, lithium aluminum oxide, neodymium gallium oxide, lanthanum strontium aluminum tantalum oxide, strontium titanium oxide, titanium oxide, hafnium, tungsten and molybdenum. Above all, use of a material having a hexagonal crystal structure such as sapphire and SiC is preferable from the point that a Group III nitride semiconductor of superior crystallinity can be laminated, and use of sapphire is most preferable.
Moreover, as for the size of the substrate, a substrate with an approximately 2-inch diameter is used in general. However, for the Group III nitride semiconductor of the present invention, a substrate with a diameter of 4 to 6-inches may be used.

By forming the buffer layer without use of ammonia while forming a base layer that constitutes an n-type semiconductor layer described later in a method with use of ammonia, in those cases where, of the above-mentioned substrate materials, an oxide substrate or a metal substrate, which are known to undergo chemical degeneration upon contact with ammonia at high temperature, is used, the buffer layer of the present embodiment acts as a coating layer and is therefore effective in preventing the chemical degeneration of the substrate. Further, the temperature of the substrate can generally be suppressed to a low level in the sputtering method, meaning that even in those cases where a substrate formed of a material that undergoes decomposition at high temperature is used, each of the layers can be formed on the substrate without damaging the substrate.

### "Buffer Layer"

The laminated semiconductor 10 of the present embodiment is such that on the substrate 11 composed of sapphire, there is provided a buffer layer 12 that is formed by means of a reactive sputtering method and that is composed of at least a Group III nitride compound. The buffer layer 12 can be formed by means of a reactive sputtering method in which a metallic Al material and a gas containing a nitrogen element are activated with a plasma.
Such a film of the present embodiment formed in a method with use of a metallic material in a plasma state, has an effect such that an orientation can easily be obtained therein.

The Group III nitride compound crystals that constitute such a buffer layer have a hexagonal crystal structure, and by controlling the film forming conditions, they can be formed as a single crystal film. Moreover, by controlling the film forming conditions, the Group III nitride compound crystals can be formed as columnar crystals composed of a texture based on hexagonal columns. Here, "columnar crystals" refers to crystals in which a crystal grain boundary is formed between adjacent crystal grains, and the crystals themselves adopt a columnar shape in a longitudinal cross-section.

It is preferable that the buffer layer 12 be of a single crystal structure in terms of the buffering function. As described above, the Group III nitride compound crystals have hexagonal crystals, and form a texture based on hexagonal columns. By controlling the film forming conditions, the Group III nitride compound crystals can be formed as crystals that have also grown in the in-plane direction. When this type of buffer layer 12 having a single crystal structure is formed on the substrate 11, the buffering function of the buffer layer 12 is particularly effective, and as a result, the Group III nitride semiconductor layer formed on top of the buffer layer 12 becomes a crystalline film having a superior orientation property and crystallinity.

It is preferable that the film thickness of the buffer layer 12 be in a range from 10 to 500 nm. With the film thickness of the buffer layer 12 in this range, there can be obtained the buffer layer 12 that has a favorable orientation and that functions effectively as a coating layer when forming each of the Group III nitride semiconductor layers on the buffer layer.
If the film thickness of the buffer layer 12 is 10 nm or lower, then there is a possibility that it may not sufficiently function as the coating layer described above. Moreover, in those cases where the buffer layer 12 is formed with a film thickness that exceeds 500 nm, there is a possibility that the film forming processing time may become longer while no changes occur in its function as the coating layer, and the productivity may be reduced.
Furthermore, it is preferable that the film thickness of the buffer layer 12 be in a range from 20 to 100 nm.

In the present embodiment, it is preferable that the buffer layer 12 be of a composition comprising AlN.
In general, the buffer layer to be laminated on the substrate is preferably of a composition containing Al, and any type of material may be used, provided that the material is of a Group III nitride compound expressed in a general formula AlGaInN. Furthermore, the buffer layer may be of a group-V composition containing As or P. In particular, if the buffer layer is of a composition containing Al, it is preferably GaAlN, and in this case, it is preferable that Al in the composition be 50% or higher. Moreover, the buffer layer 12 is most preferable to be composed of AlN.

Moreover, as the material that constitutes the buffer layer 12, one having a crystal structure the same as that of a Group III nitride semiconductor may be used, however, one with a lattice length similar to that of the Group III nitride semiconductor that constitutes the base layer is preferable, and a nitride compound having a Group IIIA element of the Periodic Table is particularly preferable.

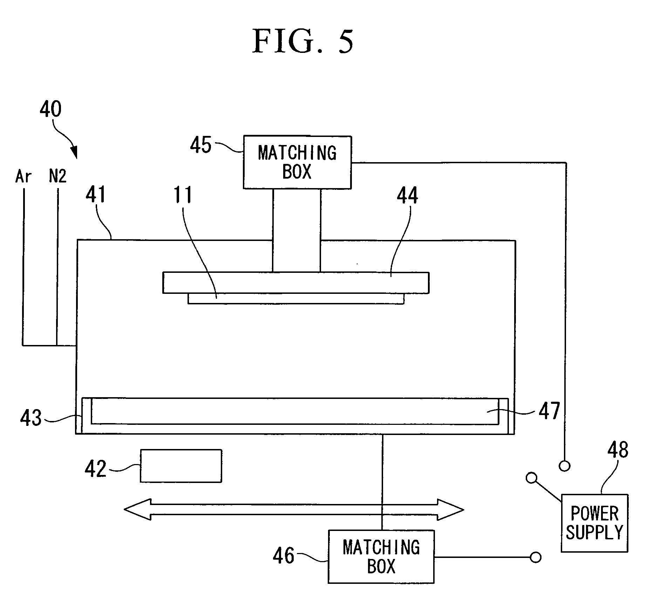

It is preferable that the buffer layer 12 contain oxygen, and the oxygen concentration in the buffer layer 12 be 1 atomic percent or lower.
If the oxygen concentration in the buffer layer exceeds 1 atomic percent, then oxygen in the film becomes excessive, the consistency of lattice constant between the substrate and the buffer layer is reduced, and its function as a buffer layer is conjectured to be reduced.
In those cases where the buffer layer is formed by means of a reactive sputtering method as practiced in the present embodiment, oxygen-containing substances such as moisture attached on the inner wall of the chamber of the sputtering apparatus (refer to reference symbol 41 in FIG. 5) are expelled from the inner wall of the chamber into the space within the chamber when performing a sputtering film forming processing, and oxygen gets mixed in the buffer layer to be formed on the substrate. Accordingly, the buffer layer formed by means of the sputtering method becomes a film that at least contains a certain level of oxygen. However, in those cases where the buffer layer 12 is formed with AlN, it contains a small amount of oxygen within the above-mentioned range (concentration upper limit: 1 atomic percent), its lattice constant becomes similar to that of the sapphire made substrate, the consistency of the lattice constant between the substrate and the buffer layer is improved, and the orientation property of the buffer layer is improved. Consequently, the crystallinity of the Group III nitride semiconductor formed on the buffer layer can be improved. Here, the amount of oxygen contained in the buffer layer 12 may be at a low concentration as shown with the above upper limit value, and the buffer layer 12 can obtain the above effect by containing a considerably small amount of oxygen.
Moreover, the oxygen concentration in the buffer layer 12 is preferably 0.8 atomic percent or lower.

In the present embodiment, by controlling the concentration of oxygen contained in the buffer layer 12 within the above-mentioned range, the lattice consistency between the buffer layer 12 composed of AlN and the substrate 11 composed of sapphire is improved, and consequently the buffer layer 12 becomes a layer having a superior orientation. The Group III nitride semiconductor formed on such a buffer layer 12 becomes a layer having superior crystallinity, and it is consequently possible to realize a Group III nitride semiconductor light-emitting device having a superior light emission property.

In the present embodiment, it is preferable that in-film oxygen concentration distribution of the buffer layer 12 be substantially uniform.
By making even and uniform the in-film oxygen distribution within the buffer layer 12, it is possible to further improve the above-mentioned lattice consistency with the substrate 11. Consequently, the crystallinity of the Group III nitride semiconductor on the buffer layer 12 can be further improved, and it is also possible to realize a Group III nitride semiconductor light-emitting device having an even more superior light emission property.

### "Semiconductor Layer"

As shown in FIG. 1, the laminated semiconductor 10 of the present embodiment is such that on the substrate 11, via the buffer layer 12, there is laminated the semiconductor layer 20 that is prepared with a Group III nitride semiconductor and that is configured with the n-type semiconductor layer 14, the light-emitting layer 15, and the p-type semiconductor layer 16. Moreover, the laminated semiconductor 10 of the illustrated example is such that a base layer 14a provided within the n-type semiconductor layer 14 is laminated on the buffer layer 12.

As the Group III nitride semiconductor, there are known many types of gallium nitride-based compound semiconductors expressed in the general formula Al_{X}Ga_{Y}In_{Z}N_{1-A}M_{A} (0 ≤ X ≤ 1, 0 ≤ Y ≤ 1, 0 ≤ Z ≤ 1, provided X + Y + Z = 1, and symbol M refers to another group-V element, which is different from nitrogen (N), and 0 ≤ A < 1), and also in the present invention, any type of gallium nitride-based compound semiconductor that is expressed in the general formula Al_{X}Ga_{Y}In_{Z}N_{1-A}M_{A} (0 ≤ X ≤ 1, 0 ≤ Y ≤ 1, 0 ≤ Z ≤ 1, provided X + Y + Z = 1, and symbol M refers to another group-V element, which is different from nitrogen (N), and 0 ≤ A < 1) including these widely known gallium nitride-based compound semiconductors, may be used without any particular restrictions.

The gallium nitride-based compound semiconductor may also contain another Group III elements other than Al, Ga, and In, and, if necessary, it may also contain an element such as Ge, Si, Mg, Ca, Zn, Be, P, or As. Moreover, the semiconductor may include not only elements that have been intentionally added, but also impurities that are unavoidably incorporated as a result of the film formation conditions employed, and very small quantities of impurities included in raw materials or reaction tube materials.

### 'n-Type Semiconductor Layer'

The n-type semiconductor layer 14, usually, is laminated on the buffer layer 12, and is configured with the base layer 14a, the n-type contact layer 14b, and an n-type cladding layer 14c. The n-type contact layer can also function as a base layer and/or an n-type cladding layer, whereas the base layer can also function as an n-type contact layer.

### {Base Layer}

The base layer 14a of the present embodiment is prepared with a Group III nitride semiconductor, and is formed into a film by being laminated on the buffer layer 12 by means of a conventionally known MOCVD method.
The material of the base layer 14a does not always have to be same as that of the buffer layer 12 formed on the substrate 11 and a different material may be used therefor. However, it is preferably configured with an Al_{y}Ga_{1-y}N layer (0 ≤ y ≤ 1, preferably 0 ≤ y ≤ 0.5, and more preferably 0 ≤ y ≤ 0.1).

As the material used for the base layer 14a, a Group III nitride compound containing Ga, that is, a GaN-based compound semiconductor is used, and in particular, AlGaN or GaN may be suitably used.
Moreover, in those cases where the buffer layer 12 is formed as a columnar crystalline aggregate composed of AlN, in order to ensure that the base layer 14a does not simply inherit the crystallinity of the buffer layer 12, migration must be used to loop the dislocation. However, a GaN-based compound semiconductor containing the above Ga can also be taken as an example of such material, and AlGaN or GaN is particularly suitable.

The preferable film thickness of the base layer 14a is within a range from 0.1 to 8 µm from the point that a base layer having superior crystallinity can be obtained, and the more preferable film thickness is within a range from 0.1 to 2 µm from the point that the amount of processing time required for film formation can be reduced and the productivity can be consequently improved.

If necessary, the base layer 14a may be doped with an n-type impurity, provided the doping quantity is within a range from 1 × 10¹⁷ to 1 × 10¹⁹/cm³, but an undoped layer (< 1 × 10¹⁷/cm³) may also be formed, and an undoped layer is preferred in terms of maintaining favorable crystallinity.
In those cases where the substrate 11 has conductivity, by doping the base layer 14a with a dopant to make the layer conductive, electrodes can be formed on the top and bottom of the light-emitting device. In contrast, in those cases where an insulating material is used as the substrate 11, because a chip structure must be adopted in which both the positive electrode and the negative electrode are provided on the same surface of the light-emitting device, forming the base layer 14a from an undoped crystal yields superior crystallinity and is consequently preferred. There are no particular limitations on the n-type impurity, and suitable examples include Si, Ge and Sn, and of these, Si and Ge are preferred.

### {n-Type Contact Layer}

The n-type contact layer 14b of the present embodiment is prepared from a Group III nitride semiconductor, and is formed into a film by being laminated on the base layer 14a by means of a MOCVD method or a sputtering method.
In the same manner as the base layer 14a, the n-type contact layer 14b is preferably formed of an AlₓGa₁₋ₓN layer (wherein, 0 ≤ x ≤ 1, preferably 0 ≤ x ≤ 0.5, and more preferably 0 ≤ x ≤ 0.1). Further, it is preferably doped with an n-type impurity, and incorporating the n-type impurity at a concentration of 1 × 10¹⁷ to 1 × 10¹⁹/cm³, and preferably 1 × 10¹⁸ to 1 × 10¹⁹/cm³ is preferred in terms of maintaining a favorable ohmic contact with the negative electrode, suppressing the occurrence of cracking, and maintaining a favorable level of crystallinity. There are no particular limitations on the n-type impurity, and suitable examples include Si, Ge and Sn, and of these, Si and Ge are preferred. The temperature for growing the n-type contact layer 14b is similar to that in the case of the base layer. Moreover, as described above, the n-type contact layer 14b may be formed to also function as a base layer.

The gallium nitride-based compound semiconductors that constitute the base layer 14a and the n-type contact layer 14b are preferably of the same composition, and the combined thickness of these layers is typically set within a range from 0.1 to 20 µm, preferably from 0.5 to 15 µm, and more preferably from 1 to 12 µm. Provided the thickness is within this range, the crystallinity of the semiconductor can be favorably maintained.

### {n-Type Cladding Layer}

The n-type cladding layer 14c is preferably provided between the above-mentioned n-type contact layer 14b and the light-emitting layer 15 described in detail later. By providing the n-type cladding layer 14c, it is possible to remedy deterioration occurring in the smoothness of the top most surface of the n-type contact layer 14b. The n-type cladding layer 14c can be formed using AlGaN, GaN or GaInN or the like by means of a MOCVD method or the like. Further, the n-type cladding layer 14c may be either a heterojunction of these structures or a superlattice structure formed by laminating a plurality of layers. When the n-type cladding layer 14c is formed of GaInN, needless to say, it is preferable that the band gap be larger than the band gap of the GaInN of the light-emitting layer 15.

The film thickness of the n-type cladding layer 14c is not particularly restricted, however, it is preferably in a range from 5 to 500 nm, and more preferably, in a range from 5 to 100 nm.
Moreover, the n-type dopant concentration within the n-type cladding layer 14c is preferably within a range from 1 × 10¹⁷ to 1 × 10²⁰/cm³, and more preferably from 1 × 10¹⁸ to 1 × 10¹⁹/cm³. A dopant concentration within this range is preferred in terms of maintaining favorable crystallinity and reducing the operating voltage of the light-emitting device.

### 'p-Type Semiconductor Layer'

The p-type semiconductor layer 16, normally, is formed of a p-type cladding layer 16a and a p-type contact layer 16b, and is formed by means of a MOCVD method or a reactive sputtering method. Further, the p-type contact layer may also function as a p-type cladding layer.

The p-type semiconductor layer 16 of the present embodiment has a p-type impurity added thereto for controlling the conduction type thereof to be p-type. There are no particular limitations on the p-type impurity, however, use of Mg is preferred and Zn may be similarly used.
Moreover, there are no particular restrictions on the total film thickness of the p-type semiconductor layer 16, however, the preferred film thickness is in a range from 0.05 to 1 µm.

### {p-Type Cladding Layer}

Although there are no particular limitations on the p-type cladding layer 16a, provided it has a composition that exhibits a larger band gap energy than that of the light-emitting layer 15 described in detail later and is capable of confining a carrier in the light-emitting layer 15, examples of preferred layers include those formed of Al_{d}Ga_{1-d}N (wherein 0 < d ≤ 0.4, and preferably 0.1 ≤ d ≤ 0.3). The p-type cladding layer 16a composed of this type of AlGaN is preferred in terms of confining a carrier in the light-emitting layer 15.
Although there are no particular restrictions on the film thickness of the p-type cladding layer 16a, the preferable film thickness is in a range from 1 to 400 nm, and more preferably from 5 to 100 nm.

A p-type dopant concentration obtained as a result of adding the p-type impurity to the p-type cladding layer 16a is preferably in a range from 1 × 10¹⁸ to 5 × 10²¹/cm³, and more preferably from 1 × 10¹⁹ to 5 × 10²⁰/cm³. A p-type dopant concentration within this range enables a favorable p-type crystal to be obtained with no deterioration in the crystallinity.

### {p-Type Contact Layer}

The p-type contact layer 16b is a gallium nitride-based compound semiconductor layer that contains at least AlₑGa₁₋ₑN (wherein 0 ≤ e < 0.5, preferably 0 ≤ e ≤ 0.2, and more preferably 0 ≤ e ≤ 0.1). An Al composition within the above range is preferred in terms of maintaining a favorable level of crystallinity, and achieving a favorable ohmic contact with a p-ohmic electrode (refer to a translucent electrode 17 described below).
Although there are no particular restrictions on the film thickness of the p-type contact layer 16b, the preferable film thickness is in a range from 10 to 500 nm, and more preferably from 50 to 200 nm. A film thickness in this range is preferable in terms of light emission output.

Further, a p-type dopant concentration obtained as a result of adding the p-type impurity to the p-type contact layer 16b is preferably in a range from 1 × 10¹⁸ to 1 × 10²¹/cm³ in terms of maintaining a favorable ohmic contact, preventing the occurrence of cracking, and maintaining a favorable level of crystallinity. The p-type dopant concentration is more preferably within a range from 5 × 10¹⁹ to 5 × 10²⁰/cm³.

### 'Light-emitting layer'

The light-emitting layer 15 is a layer that is laminated on the n-type semiconductor layer 14 and has the p-type semiconductor layer 16 laminated thereon, and can be formed by means of a conventionally known MOCVD method. Moreover, the light-emitting layer 15 has, as shown in FIG. 1, a structure in which barrier layers 15a formed of a gallium nitride-based compound semiconductor and well layers 15b formed of a gallium nitride-based compound semiconductor that contains indium are laminated alternately and repeatedly, and they are laminated and formed in a manner such that, in the illustrated example, a barrier layer 15a is positioned adjacent to both the n-type semiconductor layer 14 and the p-type semiconductor layer 16.

As the barrier layer 15a, for example, a gallium nitride-based compound semiconductor such as Al_{c}Ga_{1-c}N (0 ≤ c < 0.3) that exhibits a larger band gap energy than that of the well layer 15b composed of a gallium nitride-based compound that contains indium, may be suitably used.
Further, as the well layer 15b, for example, a gallium indium nitride such as Ga₁₋ₛInₛN (0 < s < 0.4) can be used as a gallium nitride-based compound semiconductor that contains indium.

Moreover, the total film thickness of the light-emitting layer 15 is not particularly restricted. For example, the film thickness of the light-emitting layer 15 is preferably in a range from 1 to 500 nm, and the more preferable film thickness is approximately 100 nm. A film thickness in the above range contributes to an improvement in light emission output.

The semiconductor layer 20 of the present embodiment, as described above, at least contains oxygen, and is formed on the buffer layer 12, the oxygen concentration of which is 1 atomic percent or lower, and consequently it can be formed as a layer composed of a Group III nitride semiconductor having superior crystallinity. Therefore, it is possible to realize a Group III nitride semiconductor light-emitting device having a superior light emission property.

### "Translucent Positive Electrode"

The translucent positive electrode 17 is an electrode having translucency that is formed on the p-type semiconductor layer 16 (p-type contact layer 16b) of the laminated semiconductor 10 described above.
There are no particular limitations on the material used for the translucent positive electrode 17, and materials such as ITO (In₂O₃-SnO₂), AZO (ZnO-Al₂O₃), IZO (In₂O₃-ZnO), and GZO (ZnO-Ga₂O₃) can be used with use of a conventional method widely known in this technical field. Moreover, as for the structure thereof, any structure may be used without any particular limitations, including any of the conventionally known structures.
Further, the translucent positive electrode 17 may be formed so as to cover the substantially entire surface of the Mg-doped p-type semiconductor layer 16, or may be formed in a lattice shape or branched shape with gaps therein.

### "Positive Electrode Bonding Pad and Negative Electrode"

The positive electrode bonding pad 18 is an electrode formed on the translucent positive electrode 17 described above.
As the material for the positive electrode bonding pad 18, various structures using Au, Al, Ni and Cu are well known, and any of these known materials or structures may be used without any limitations.
The thickness of the positive electrode bonding pad 18 is preferably within a range from 100 to 1000 nm. Further, in terms of the bonding pad properties, a larger thickness yields superior bondability, and therefore the thickness of the positive electrode bonding pad 18 is more preferably not less than 300 nm. Moreover, from the viewpoint of production costs, the thickness is preferably not more than 500 nm.

In the semiconductor layer in which the n-type semiconductor layer 14, the light-emitting layer 15, and the p-type semiconductor layer 16 are sequentially laminated on the substrate 11, the negative electrode 19 is formed so as to come in contact with the n-type contact layer 14b of the n-type semiconductor layer 14.
Accordingly, when providing the negative electrode 19, by removing part of the p-type semiconductor layer 16, the light-emitting layer 15, and the n-type semiconductor layer 14, the exposed region 14d of the n-type contact layer 14b is formed and the negative electrode 19 is formed thereon.
As the material used for the negative electrode 19, negative electrodes having various compositions and structures are widely known, and any of these negative electrodes may be used without any particular limitations, with use of a conventional method widely known in this technical field.

According to the Group III nitride semiconductor light-emitting device 1 of the present embodiment described above, with the oxygen concentration 1 atomic percentage or lower in the buffer layer 12 formed by means of reactive sputtering, the crystallinity of the semiconductor layer 20 composed with the Group III nitride semiconductor laminated on the buffer layer 12 is improved, and it is therefore possible to obtain a Group III nitride semiconductor light-emitting device having a superior light emission property.

### [Method for manufacturing a Group III Nitride Semiconductor Light-Emitting Device]

A method for manufacturing a Group III nitride semiconductor light-emitting device of the present embodiment is a method such that the buffer layer 12 composed of at least a Group III nitride compound is laminated on a sapphire substrate 11, and the n-type semiconductor layer 14, the light-emitting layer 15, and the p-type semiconductor layer 16 are laminated in a sequential manner on the buffer layer 12, and the buffer layer 12 is formed by means of a reactive sputtering method, the buffer layer 12 contains oxygen, and the oxygen concentration in the buffer layer 12 is 1 atomic percent or lower.

In the manufacturing method of the present embodiment, crystals of the Group III nitride semiconductor are epitaxially grown on the substrate 11, and when forming the laminated semiconductor 10 shown in FIG. 1, the buffer layer 12 is formed on the substrate 11 and the semiconductor layer 20 is formed thereon. In the present embodiment, the method is such that: the buffer layer 12 is formed of AlN by means of a reactive sputtering method, in which a metallic Al material and a gas containing a nitrogen element are activated with a plasma; the base layer 14a of the n-type semiconductor layer 14 is formed thereon by means of a MOCVD method; then the n-type contact layer 14b is formed by means of a sputtering method; each layer of the n-type cladding layer 14c and the light-emitting layer 15 thereon is formed by means of a MOCVD method; and then the p-type semiconductor layer 16 is formed by means of a sputtering method.

In the manufacturing method of the present embodiment, as illustrated with an example in the plan view of FIG. 2 and the sectional view of FIG. 3, the translucent positive electrode 17 is laminated on the p-type semiconductor layer 16 of the laminated semiconductor 10 described above, the positive electrode bonding pad 18 is formed thereon, and the negative electrode 19 is laminated on the exposed region 14d formed on the n-type contact layer 14b of the n-type semiconductor layer 14.
Hereunder, there is described in detail the method for manufacturing the Group III nitride semiconductor light-emitting device of the present embodiment.

### "Pretreatment of Substrate"

In the present embodiment, it is preferable that a pretreatment be performed by means of a sputtering method or the like after having transported the substrate 11 into a reactor and before forming the buffer layer 12. Specifically, the surface of the substrate 11 can be cleaned by exposing the substrate 11 to an Ar or N₂ plasma. For example, by performing reverse sputtering, in which the surface of the substrate 11 is treated with a plasma of Ar gas, N₂ gas, or the like, any organic material or oxides adhered to the surface of the substrate 11 can be removed. In such a case, if a voltage is applied between the substrate 11 and the chamber, then the plasma particles will act efficiently on the substrate 11. By performing such pretreatment on the substrate 11, the buffer layer 12 can be formed on an entire surface 11a of the substrate 11, and the crystallinity of the film to be formed thereon can be increased.
Moreover, it is preferable that a wet pretreatment be performed on the substrate 11 before the above-mentioned pretreatment is performed by means of reverse sputtering.

Further, it is preferable that the pretreatment to be performed on the substrate 11 be performed with a plasma treatment performed in a gas in which an ionic component and a radical component having no electric charge are mixed, as with the above-mentioned reverse sputtering.
Here, there is a problem in that when removing contamination and the like from the surface of the substrate, for example, in those cases where an ionic component or the like is singly supplied onto the substrate surface, the intensity of energy is too high, consequently damaging the substrate surface, and the quality of crystals to be grown on the substrate is reduced as a result.
In the present embodiment, as the pretreatment to the substrate 11, with use of the above-mentioned plasma treatment performed in a gas in which an ionic component and a radical component are mixed, the substrate 11 is treated with reactive substance having an appropriate level of energy, and it is thereby possible to remove contamination and the like without damaging the surface of the substrate 11. There may be considered a mechanism in which such effect can be obtained such that: damage to the substrate surface can be suppressed with use of a plasma with a low ionic component ratio; and contamination can be effectively removed by treating the substrate surface with the plasma.

### "Formation of Buffer Layer"

In the present embodiment, the buffer layer 12 is formed on the substrate 11 by means of a reactive sputtering method, such that the buffer layer 12 contains oxygen, and the oxygen concentration in the buffer layer 12 is 1 atomic percent or lower. Moreover, in the present example, there is provided a method in which the buffer layer 12 is formed of AlN by means of reactive sputtering, in which a metallic Al material and a gas containing a nitrogen element are activated with a plasma, and it is formed under the conditions and in the procedures described in detail below.

### 'Film Formation by Means of Reactive Sputtering Method'

Having performed the pretreatment on the surface of the substrate 11, a gas containing argon and nitrogen is supplied into the interior of the chamber 41 of a sputtering apparatus 40 (refer to FIG. 5), and the substrate 11 is heated to approximately 500°C. Then, a high-frequency bias is applied to the substrate 11 side while power is applied to an Al target side that uses metallic Al as a Group III metallic material to generate a plasma within the chamber 41, and thereby the buffer layer 12 composed of AlN is formed on the substrate 11 while the pressure within the chamber 41 is maintained constant.
Specific examples of the method of forming the buffer layer 12 on the substrate 11 include, in addition to a reactive sputtering method, a MOCVD method, a pulsed laser deposition (PLD) method, and a pulsed electron beam deposition (PED) method, and one may be appropriately selected therefrom for use. However, the reactive sputtering method is a suitable method because it is simplest and suitable for mass production.

### (Sputtering Apparatus)

In the sputtering apparatus 40 in the example shown in FIG. 5, a magnet 42 is arranged below (underside in FIG. 5) a metallic target 47, and the magnet 42 is swung below the metallic target 47 by a driving apparatus. A nitrogen gas and an argon gas are supplied into the chamber 41, and a buffer layer is formed on the substrate 11 that is attached on a heater 44. At this time, the magnet 42 is swinging below the metallic target 47 as described above, and therefore the plasma confined within the chamber 41 moves and the buffer layer can be uniformly formed on the surface 11 a as well as the side surface of the substrate 11.

Specific examples of the method of forming the buffering layer by means of the sputtering method include a RF sputtering method and a DC sputtering method. Here, it is known that in those cases where film formation is performed by means of the reactive sputtering method with use of a nitrogen gas as a nitrogen element containing gas, as practiced in the manufacturing method according to the present invention, nitrogen is adsorbed on the target surface (metallic material) (refer to Mat. Res. Soc. Symp. Proc. Vol. 68, 357, 1986). In general, use of the DC sputtering method is suitable in a case of sputtering with use of a metallic material target in terms of film formation efficiency. However, in the DC sputtering method, in which discharging is continuously performed, nitrogen becomes adhered to the target and this tends to invite charge-up of the target surface and instability may occur in the film formation rate. For this reason, in the manufacturing method according to the present invention, use of the RF sputtering method, or use of a pulsed DC sputtering method among the DC sputtering methods, in which the bias is applied in a pulsed manner, is preferred, and use of a sputtering apparatus capable of performing a treatment with such a sputtering method is preferred.

Moreover, in those cases where the buffer layer 12 is formed by means of a sputtering method, use of a reactive sputtering method, in which a nitrogen-containing gas is supplied into the reactor, in the film formation is preferable from the point that the crystallinity can be maintained at a favorable level by controlling the reaction and this favorable crystallinity can be stably reproduced, and use of a sputtering apparatus that is capable of performing the treatment with such a reactive sputtering method is preferable.

Moreover, in those cases where a sputtering apparatus that uses a RF sputtering method is used, as a method of avoiding charge-up, it is preferable that the position of the magnet be moved within the target. The specific method of moving the magnet may be selected in accordance with the apparatus to be used, and it may be either swung or rotated. The sputtering apparatus 40 illustrated as an example in FIG. 5 is provided with the magnet 42 under the target 47, and has a configuration that allows this magnet 42 to rotate under the target 47.

Moreover, in the reactive sputtering method, there is generally used a technique for improving efficiency by confining the plasma within a magnetic field. At this time, as a method for unbiased use of the target, as with the sputtering apparatus 40 described above, use of the RF sputtering method is preferred in which the film formation is performed while the position of the cathode magnet 42 is moved within the target 47. The specific method of moving the magnet in such a case may be appropriately selected in accordance with the sputtering apparatus to be used, and for example, the magnet may be either swung or rotated.

Moreover, although described in detail later, it is preferable that impurities not be left within the chamber 41 to the best possible extent, in particular, oxygen-containing substances adhered on the inner wall of the chamber 41 be reduced to the best possible extent, and accordingly, the preferred ultimate vacuum within the chamber 41 of the sputtering apparatus 40 is 1.0 × 10⁻⁴ Pa or lower.

Moreover, it is preferable that the buffer layer 12 be formed so as to cover the side surface of the substrate 11, and it is most preferably formed so as to cover the side surface as well as the back surface of the substrate 11.
However, in those cases where the buffer layer is formed with use of a conventional sputtering apparatus and film forming method, the film forming treatment needs to be performed approximately six times to eight times at most, and the treatment process requires a long period of time. As a film forming method other than this, there may considered a method in which the substrate is disposed within the chamber without being held to thereby form the film on the entire substrate surface, however, the apparatus may become complex in those cases where the substrate needs to be heated.
Consequently, for example, with use of a sputtering apparatus that allows the substrate to be either swung or rotated, the film can be formed while the position of the substrate is changed with respect to the direction of sputtering the film forming material. With such a sputtering apparatus and film forming method, the film formation can be performed on the surface and side surface of the substrate in a single process, and by performing the subsequent film forming process on the back surface of the substrate, the entire surface of the substrate can be covered in a total of two processes.

Furthermore, the sputtering apparatus may be such that with a configuration in which the film forming material is generated from a source (target) having a large area, by moving the position of generating the material, the film formation can be performed on the entire surface of the substrate without moving the substrate. As an example of such an apparatus, there may be taken an apparatus that uses a RF sputtering method, such as the sputtering apparatus 40 shown in FIG. 5 in which the magnet is either swung or rotated and thereby the position of the cathode magnet within the target is moved while performing the film formation. Moreover, in those cases where the film formation is performed by means of such a RF sputtering method, there may be employed an apparatus in which both of the substrate side and the cathode side are moved. Furthermore, with a configuration such that by arranging the cathode, which is the material generation source (refer to target tray 43 in FIG. 5), in the proximity of the substrate, generated plasma, rather than being supplied onto the substrate as a beam, is supplied so as to encompass the substrate, it is possible to perform simultaneous film formations on the surface and side surface of the substrate.

### (Nitrogen-containing gas)

As the nitrogen-containing gas used in the present embodiment, any generally known nitrogen compound can be used without any limitations, although ammonia and nitrogen (N₂) gas are preferred, as they are easy to handle and can be obtained comparatively cheaply.
Decomposition efficiency of ammonia is favorable and it enables film formation at a high growth rate, however, because of its high reactivity and toxicity, a facility for toxicity removal and a gas detector are required, and furthermore, the material of the member to be used in the reaction apparatus needs to be chemically highly stable.
Moreover, in those cases where nitrogen (N₂) is used as a material, a simple apparatus may be used, however, a high reaction rate cannot be achieved. However, if a method is used in which the nitrogen is decomposed using an electric field or heat or the like prior to introduction into the apparatus, then a film formation rate can be achieved which, although being lower than that obtained using ammonia, is still sufficient for use in industrial production, and therefore if due consideration is also given to the cost of the apparatus, N₂ is the most favorable nitrogen source.

The preferable nitrogen fraction within the nitrogen-containing gas, that is, the preferable flow rate of nitrogen with respect to the flow rate of nitrogen (N₂) and Ar is 20% or higher. If nitrogen is 20% or lower, then the amount of nitrogen present becomes small and the metal becomes deposited upon the substrate 11, and consequently the buffer layer 12 does not have the crystal structure required in the Group III nitride compound. Moreover, a nitrogen flow rate higher than 99% is not preferable, because the amount of Ar becomes overly small and the sputtering rate is significantly reduced. Moreover, the more preferred gas fraction rate of the nitrogen within the nitrogen-containing gas is in a range from 40% or higher to 95% or lower, and most preferably from 60% or higher to 80% or lower.

In the present embodiment, migration on the substrate 11 can be suppressed by supplying active nitrogen onto the substrate 11, and thereby self-assembly can suppressed and the buffer layer 12 can be appropriately formed as a single crystal structured layer. In the buffer layer 12, by appropriately controlling the single crystal structure, the crystallinity of the semiconductor layer composed of GaN (Group III nitride semiconductor) that is laminated thereon can be controlled at a favorable level.

### (Pressure Inside Chamber)

The preferred pressure within the chamber 41 when forming the buffer layer 12 by means of the reactive sputtering method is 0.2 Pa or higher. If this pressure within the chamber 41 is lower than 0.2 Pa, then the kinetic energy of the occurring reactive substance becomes overly high, and consequently the film quality of the buffer layer to be formed becomes insufficient. Furthermore, although there are no particular limitations on the upper limit of the pressure within the chamber 41, if the pressure becomes 0.8 Pa or higher, then charged particles of dimers that contribute to the orientation of the film, and charged particles in the plasma interact with each other, and therefore the preferred pressure within the chamber 41 is in a range from 0.2 to 0.8 Pa.

### (Ultimate Vacuum of Sputtering Apparatus)

In the manufacturing method of the present embodiment, it is preferable that under a condition where the ultimate vacuum within the chamber 41 of the sputtering apparatus 40 used for forming the buffer layer 12 is 1.5 × 10⁻⁵ Pa or lower, the degree of vacuum within in the chamber 41 be brought into this range and then the buffer layer 12 be formed.
As described above, in those cases where the buffer layer is formed by means of the reactive sputtering method, oxygen-containing substances such as moisture adhered on the inner wall of the chamber 41 of the sputtering apparatus 40 are expelled from the inner wall of the chamber 41 when performing the sputtering film formation process, and they inevitably get mixed in the buffer layer 12 formed on the substrate 11. Such oxygen-containing substances are primarily thought to occur such that oxygen and moisture in the atmosphere enter the inside of the chamber 41 and become adhered on the inner wall when the chamber 41 is opened to the atmosphere for performing maintenance.

The inventors carried out intensive investigation and discovered that it is possible to obtain an effect such that the buffer layer 12 composed of AlN contains a small amount (low concentration) of oxygen due to the mixture of oxygen that occurs when sputtering, and consequently its lattice constant becomes similar to that of the sapphire-made substrate 11 and the consistency of lattice constant between the substrate 11 and the buffer layer 12 is improved, and the orientation property of the buffer layer 12 is improved.
However, meanwhile, if a large amount of oxygen gets mixed within the buffer layer formed on the substrate and the oxygen concentration in the film becomes overly high (higher than 1 atomic percent), the consistency of the lattice constant between the substrate and the buffer layer is reduced, and the orientation property of the buffer layer is reduced. That is to say, in those cases where a large amount of oxygen-containing substances becomes adhered on the chamber inner wall of the sputtering apparatus, a large amount of oxygen gets mixed in the buffer layer when sputtering, and the above-mentioned problem occurs.

In the present embodiment, a method is adopted such that the inside of the chamber 41 of the sputtering apparatus 40 used for forming the buffer layer 12 is evacuated to be less than 1.5 × 10⁻⁵ Pa or lower; and while maintaining the degree of vacuum in such a range, oxygen-containing substances within the chamber 41 are absorbed, and the oxygen-containing substances adhered on the inner wall of the chamber 41 and the oxygen-containing substances present in the space within the chamber 41 can be removed and reduced, and, after then, the buffer layer 12 is formed.
Thereby, the buffer layer 12 composed of AlN can be formed in a state of containing oxygen at a very low concentration, which is 1 atomic percent or lower, and consequently, the lattice of the buffer layer 12 matches with that of the sapphire substrate 11 and excellent orientation of the buffer layer is achieved. Therefore, the crystallinity of the semiconductor layer 20 formed with the Group III nitride semiconductor formed on this buffer layer 12 is improved, and there can be obtained the light-emitting device 1 having a superior light emission property.

### (Dummy Discharge)

In the manufacturing method of the present embodiment, in order to improve the above-mentioned ultimate vacuum, it is preferable that dummy discharging without the film forming process be performed within the chamber 41 of the sputtering apparatus 40 before performing the process of sputtering film formation of the buffer layer 12.
As the method of dummy discharging, generally, a discharging program similar to that of the film forming process is performed without introducing the substrate. By performing dummy discharging in such method, even if the components to be expelled are unknown and the mechanism of a component to be expelled as impurities is unknown, it is possible to preliminarily expel impurities that may emerge under the film forming condition.
Moreover, such dummy discharging can also be performed under a condition where impurities can be expelled more easily compared to the method that is performed under a condition similar to the normal film forming condition. Specific examples of such a condition include a condition where the set temperature for heating the substrate is set relatively high (heater 44 in the sputtering apparatus 40 in FIG. 5), and a condition where the power for generating plasma is set relatively high.
Furthermore, the dummy discharging described above can also be performed at the same time as suction in the chamber 41 is performed.

By performing the above-mentioned dummy discharging, the ultimate vacuum within the chamber 41 before film formation is increased, and it is thereby possible to more reliably remove and reduce the oxygen-containing substances present on the inner wall of and in the space within the chamber 41. Therefore, the lattice consistency between the substrate 11 and the buffer layer 12 is further improved, and it is possible to further enhance the orientation property of the buffer layer 12.

### (Film Formation Rate)

The film formation rate when forming the buffer layer 12 is preferably in a range from 0.01 nm/s to 10 nm/s. If the film formation rate is lower than 0.01 nm/s, the film is not formed into a layer and grows into an island shape, and consequently, it may not be able to cover the surface of the substrate 11. If the film formation rate exceeds 10 nm/s, the film does not become a crystalline body and becomes amorphous.

### (Substrate Temperature)

The preferred temperature of the substrate 11 when forming the buffer layer 12 is in a range from room temperature to 1000°C, and more preferably from 400 to 800°C. If the temperature of the substrate 11 is lower than the above lower limit, the buffer layer 12 may not be able to cover the entire surface of the substrate 11 and the surface of the substrate 11 may be exposed. A temperature of the substrate 11 exceeding the above upper limit is not appropriate because it would cause migration of the metallic materials to become active. The room temperature described in the present invention is a temperature that is also influenced by the process environment and the like, however, the temperature is specifically in a range from 0 to 30°C.

### (Target)

When mixed crystals are formed as the buffer layer with use of a reactive sputtering method, in which a Group III metallic material and a nitrogen-containing gas are activated with plasma, for example, there may be used a method that uses a mixed metallic material including Al or the like (this does not always have to be formed as an alloy metal) as a target, and there may also be used a method in which two targets made from different materials are prepared and are sputtered at the same time. For example, a target of a mixed material may be used in the case of forming a film having a constant composition, and a plurality of targets may be installed within the chamber in the case of forming several types of films having different compositions.

### "Formation of Semiconductor Layer"

The n-type semiconductor layer 14, the light-emitting layer 15, and the p-type semiconductor layer 16 are laminated in this order on the buffer layer 12, thereby forming the semiconductor layer 20. In the manufacturing method of the present embodiment, as described above, having formed the base layer 14a of the n-type semiconductor layer 14 by means of a MOCVD method, the n-type contact layer 14b is formed by means of a sputtering method, each layer of the n-type cladding layer 14c and the light-emitting layer 15 thereabove is formed by means of a MOCVD method, and then the p-type semiconductor layer 16 is formed by means of a sputtering method.

In the present embodiment, the method of growing the gallium nitride-based compound semiconductor when forming the semiconductor layer 20 is not particularly limited, and in addition to the above-mentioned sputtering method, all methods that are known to grow nitride semiconductors including MOCVD (metal-organic chemical vapor deposition methods), HVPE (hydride vapor phase epitaxy methods), MBE (molecular beam epitaxy methods) may be used. Among these methods, in the MOCVD method, hydrogen (H₂) or nitrogen (N₂) can be used as the carrier gas, trimethyl gallium (TMG) or triethyl gallium (TEG) can be used as the Ga source that represents the Group III raw material, trimethyl aluminum (TMA) or triethyl aluminum (TEA) can be used as the Al source, trimethyl indium (TMI) or triethyl indium (TEI) can be used as the In source, and ammonia (NH₃) or hydrazine (N₂H₄) can be used as the N source that represents the group-V raw material. As the dopant, for the n-type, monosilane (SiH₄) or disilane (Si₂H₆) can be used as the Si raw material and germane gas (GeH₄) or an organogermanium compound such as tetramethyl germanium ((CH₃)₄Ge) or tetraethyl germanium ((C₂H₅)₄Ge) can be used as the Ge raw material. In the MBE method, a germanium element can also be used as the dopant source. For the p-type, for example, biscyclopentadienyl magnesium (Cp₂Mg) or bisethylcyclopentadienyl magnesium (EtCp₂Mg) can be used as the Mg raw material.

The gallium nitride-based compound semiconductor described above may also contain another Group III element other than Al, Ga, and In, and, if necessary, it may also contain a dopant element such as Ge, Si, Mg, Ca, Zn, or Be. Moreover, the semiconductor may include not only elements that have been intentionally added, but also impurities that are unavoidably incorporated as a result of the film formation conditions employed, and very small quantities of impurities included in raw materials or reaction tube materials.

### 'Formation of n-Type Semiconductor Layer'

When forming the semiconductor layer 20 of the present embodiment, first, the base layer 14a of the n-type semiconductor layer 14 is laminated and formed on the buffer layer 12 by means of a conventionally known MOCVD method. Next, having formed the n-type contact layer 14b on the base layer 14a by means of a sputtering method, the n-type cladding layer 14c is formed by means of a MOCVD method. At this time, each layer of the base layer 14a and the n-type cladding layer 14c can be formed with use of the same MOCVD furnace. In the present embodiment, there has been described an example of forming the n-type contact layer 14b by means of a sputtering method, however, it may be formed by means of a MOCVD method.

### 'Formation of Light-Emitting Layer'

The light-emitting layer 15 is formed on the n-type cladding layer 14c by means of a conventionally known MOCVD method.
The light-emitting layer 15 to be formed in the present embodiment, which is illustrated in the example of FIG. 1, has a laminated structure that starts with a GaN barrier layer and ends with a GaN barrier layer, and it is formed by alternately laminating six layers of the barrier layers 15a composed of GaN and five layers of undoped well layers 15b composed of In_{0.2}Ga_{0.8}N.
Moreover, in the manufacturing method of the present embodiment, by using the same MOCVD furnace used in forming the n-type cladding layer 14c, the light-emitting layer 15 can be formed by means of a conventionally known MOCVD method.

### 'Formation of p-Type Semiconductor Layer'

On the light-emitting layer 15, that is to say, on the barrier layer 15a that serves as the top layer of the light-emitting layer 15, there is formed, by means of a MOCVD method or a sputtering method, the p-type semiconductor layer 16 formed with the p-type cladding layer 16a and the p-type contact layer 16b.
In the present embodiment, first, the Mg-doped p-type cladding layer 16a composed of Al_{0.1}Ga_{0.9}N is formed on the light-emitting layer 15 (top barrier layer 15a), and further, the Mg-doped p-type contact layer 16b composed of Al_{0.02}Ga_{0.98}N is formed thereon. At this time, the same sputtering apparatus may be used for laminating the p-type cladding layer 16a and the p-type contact layer 16b.
As described above, as the p-type impurities, other than MG, zinc (Zn) may also be used in a similar manner for example.

### "Formation of Translucent Positive Electrode"

The translucent positive electrode 17 composed of ITO is formed on the p-type contact layer 16b of the laminated semiconductor 10, each layer of which is formed in the above-mentioned method.
The method of forming the translucent positive electrode 17 is not particularly limited, and it may be provided with use of a conventional method widely known in this technical field. Moreover, as for the structure thereof, any structure may be used without any particular limitations, including any of the conventionally known structures.

Furthermore, as described above, the material of the translucent positive electrode 17 is not limited to ITO, and it can be formed with use of materials such as AZO, IZO, or GZO.
Moreover, in some cases, thermal annealing may be conducted with the purpose of alloying or transparentizing after having formed the translucent positive electrode 17, however, it does not always have to be conducted.

### "Formation of Positive Electrode Bonding Pad and Negative Electrode"

On the translucent positive electrode 17 formed on the laminated semiconductor 10, there is further formed the positive electrode bonding pad 18.
This positive electrode bonding pad 18 can be formed, for example, by laminating each of materials Ti, Al, and Au in a sequential manner from the surface side of the translucent positive electrode 17 with use of a conventionally known method.

Moreover, when forming the negative electrode 19, first, the p-type semiconductor layer 16, the light-emitting layer 15, and the n-type semiconductor layer 14 formed on the substrate 11 are partially removed by means of dry etching or the like, and thereby the exposed region 14d of the n-type contact layer 14b is formed (refer to FIG. 2 and FIG. 3). Then, on this exposed region 14d, for example, by laminating each of materials Ni, Al, Ti, and Au with use of a conventionally known method, there can be formed the negative electrode 19 having a four-layer structure, the detailed illustration of which is omitted.

Then having ground and polished the back surface of the substrate 11 into a mirror surface, a wafer comprising the translucent positive electrode 17, the positive electrode bonding pad 18, and the negative electrode 19 provided on the laminated semiconductor 10 as described above, is cut into square shapes having a side length of 350 µm for example, and thereby the light-emitting device chips (light-emitting devices 1) can be formed.

According to the method for manufacturing a Group III nitride semiconductor light-emitting device of the present embodiment described above, the manufacturing method is such that the buffer layer 12 composed of at least a Group III nitride compound is laminated on the sapphire substrate 11, and this buffer layer 12 is formed by means of a reactive sputtering method where the oxygen concentration in the buffer layer 12 is 1 atomic percent or lower. Therefore, it is possible to form the buffer layer 12 with increased lattice matching with the substrate 11. Consequently, the orientation property of the buffer layer 12 is improved, and it is possible to increase the crystallinity of the semiconductor layer 20 comprising the respective layers of the n-type semiconductor layer 14, the light-emitting layer 15, and the p-type semiconductor layer 16. Therefore, it is possible to obtain a Group III nitride semiconductor light-emitting device 1 that realizes superior productivity and has a superior light emission property.

Moreover, under a condition where the ultimate vacuum within the chamber 41 of the sputtering apparatus 40 used for forming the buffer layer 12 is 1.0 × 10⁻⁴ Pa or lower, oxygen-containing substances present within the chamber 41 can be reduced by suctioning inside the chamber 41 before forming the buffer layer 12, and therefore it is possible to further improve the orientation property of the buffer layer 12 formed on the substrate 11.
Furthermore, by performing dummy discharging a predetermined number of times at the same time as the inside of the chamber 41 of the sputtering apparatus 40 is suctioned to a low pressure, the ultimate vacuum within the chamber 41 can be brought to a more low pressure and the oxygen-containing substances present within the chamber 41 can be more reliably reduced. As a result, the orientation property of the buffer layer 12 formed on the substrate 11 can be further improved.

### [Lamp]

By combining the Group III nitride semiconductor light-emitting device according to the present invention and a phosphor, it is possible to configure a lamp using techniques known to those skilled in the art. Techniques for changing the light emission color by combining a light-emitting device and a phosphor are conventionally well known, and these types of techniques may be adopted without any particular restrictions.
For example, by appropriate selection of the phosphor, light emission having a longer wavelength than that of the light-emitting device can be achieved. Furthermore, by mixing the emission wavelength of the light-emitting device itself and the wavelength that has been converted by the phosphor, a lamp that emits white light can be obtained.
Furthermore, the lamp can be used within all manner of applications, including bullet-shaped lamps for general applications, side view lamps for portable backlight applications, and top view lamps used in display equipment.

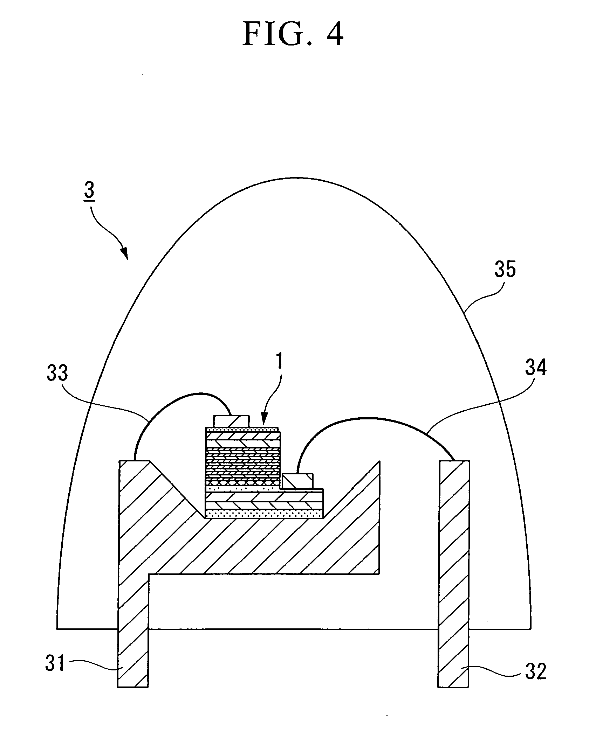

For example, in those cases where the same plane electrode type Group III nitride semiconductor light-emitting device 1 is implemented in a bullet-shaped application as with the example shown in FIG. 4, the light-emitting device 1 is bonded to one of two frames (frame 31 in FIG. 4), the negative electrode of the light-emitting device 1 (refer to reference symbol 19 shown in FIG. 3) is bonded to a frame 32 using a wire 34, and the positive electrode bonding pad (refer to reference symbol 18 in FIG. 3) of the light-emitting device 1 is bonded to the frame 31 using a wire 33. Further, by encapsulating the periphery of the light-emitting device 1 within a mold 35 formed of a transparent resin, a bullet-shaped lamp 3 shown in FIG. 4b can be manufactured.

The laminated structure of the Group III nitride semiconductor that is obtained in the present invention and that is provided with superior crystallinity may also be used, besides the semiconductor layer provided in light-emitting devices described above such as light-emitting diodes (LED) and laser discs (LD), in photoelectric conversion devices such as laser devices and light-receiving devices, and also in electronic devices such as a HBT (heterojunction bipolar transistor) and a HEMT (high electron mobility transistor). A multitude of these semiconductor devices with all manner of structures are already known, and the device structure of the laminated structure body of the Group III nitride semiconductor according to the present invention is not limited in any particular manner, and includes all of these conventional device structures.

### [Examples]

Hereunder, the Group III nitride semiconductor light-emitting device of the present invention and the manufacturing method thereof are described in detail using a series of examples, although the present invention is in no way limited by these examples.

### [Example 1]

FIG. 1 shows a cross-sectional schematic view of the laminated semiconductor of the Group III nitride compound semiconductor light-emitting device manufactured in the present experimental example.
In the present example, on the c-plane of the substrate 11 composed of sapphire, there was formed, a single crystal layer composed of AlN that serves as the buffer layer 12, and on this, there was formed, by means of reactive sputtering, a layer composed of GaN (Group III nitride semiconductor) that serves as the base layer 14a.

### "Formation of Buffer Layer"

First, a substrate formed of a 2-inch diameter (0001) c-plane sapphire that had been polished to a mirror surface was cleaned using a hydrofluoric acid and organic solvent, and then was placed inside a chamber. At this time, as the sputtering apparatus, as with the sputtering apparatus 40 illustrated in the example in FIG. 5, there was used an apparatus that has a high frequency type power supply and that has a mechanism capable of moving the position of the magnet within the target. As the target, there was used one composed of metallic Al.
Then, having heated the substrate 11 to 500°C within the chamber and supplied nitrogen gas at a flow rate 15 sccm, a 50W high frequency bias was applied to the substrate 11 side and it was exposed to nitrogen plasma while the pressure within the chamber was maintained at 1.0 Pa, to thereby clean the surface of the substrate 11.
Subsequently, the inside of the chamber was suctioned using a vacuum pump. At the same time, dummy discharging was repeatedly performed a total of 16 times and thereby the inside of the chamber of the sputtering apparatus was decompressed so as to reduce the inner pressure to 6.0 × 10⁻⁶ Pa and remove the impurities within the chamber.

Subsequently, with the temperature of the substrate 11 held at the same level, argon gas and nitrogen gas were introduced into the sputtering apparatus. A 2000 W high frequency bias was then applied to the metallic Al target side, and with the pressure inside the chamber maintained at 0.5 Pa, a single crystal buffer layer 12 formed of AlN was formed on the sapphire substrate 11 under conditions including an Ar gas flow rate of 5 sccm and a nitrogen gas flow rate of 15 sccm (ratio of nitrogen in the entire gas was 75%). The magnet within the target was swung both when the substrate 11 was being cleaned and when the film formation was being performed.
Using a pre-measured film formation rate (0.067 nm/s), treatment was conducted for a specific period of time to form an AlN layer (buffer layer 12) having a thickness of 40 nm, and the plasma operation was then halted and the temperature of the substrate 11 was reduced.

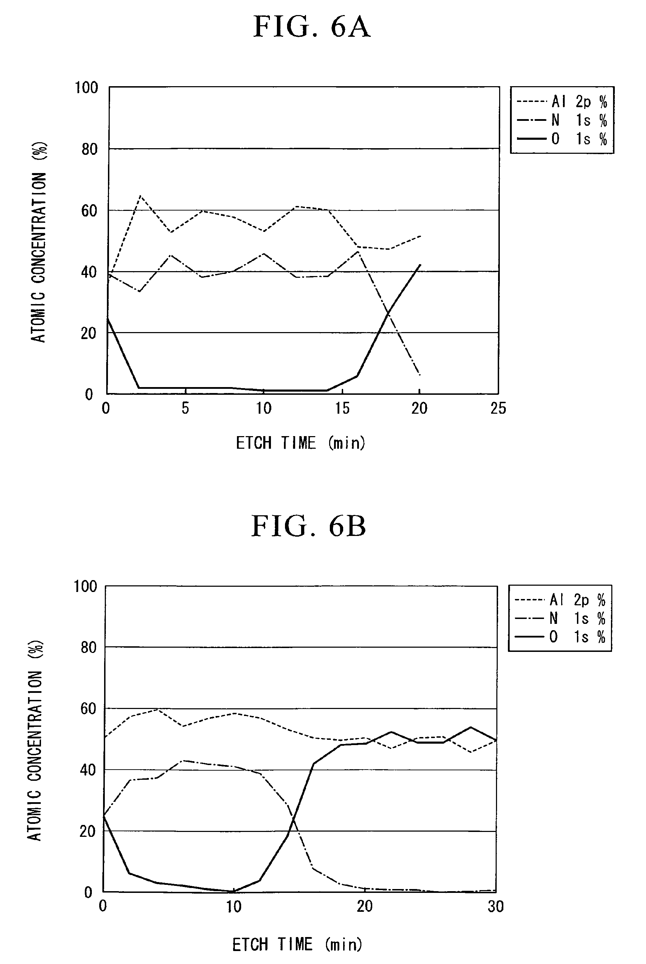

The X-ray rocking curve (XRC) for the buffer layer 12 formed on the substrate 11 was then measured using an X-ray measurement apparatus (model: X'part Pro MRD, manufactured by Spectris plc). The measurement was conducted using a CuKα X-ray beam generation source as the X-ray source. The measurement result revealed that the XRC full width at half maximum for the buffer layer 12 was 0.1°, which represents a favorable result, and confirmed that the buffer layer 12 was favorably oriented.
Moreover, the composition of the buffer layer 12 was measured using an X-ray photoelectron spectroscopy apparatus (XPS), and as shown in FIG. 6A, it was confirmed that the measurement result indicates that the oxygen concentration was 1 atomic percent or lower in the buffer layer that corresponds to the etching time from 3 minutes to 13 minutes.

### "Formation of Base Layer"

The substrate 11 having the AlN layer (buffer layer 12) formed thereon was removed from the sputtering apparatus and transported into a MOCVD apparatus, and a base layer 14a formed of GaN was then formed on the buffer layer 12 using the procedure described below.
First, the substrate 11 was transported into the reaction furnace (MOCVD apparatus), and was loaded on a carbon made heating susceptor within a nitrogen gas-replaced glove-box. Subsequently, having supplied nitrogen gas into the reaction furnace, the heater was operated to raise the substrate temperature to 1150°C. Then, after the temperature was confirmed to have been stabilized at 1150°C, the valve of the ammonia gas piping was opened to thereby commence ammonia gas supply into the reaction furnace.
Next, hydrogen containing vapors of TMG was supplied into the reaction furnace, and then the process of forming, on the buffer layer 12, a Group III nitride semiconductor (GaN) that constitutes the base layer 14a was commenced. The amount of ammonia at this time was adjusted so that the V/III ratio was 6000. Once a GaN layer had been deposited in this manner over a period of approximately one hour, the TMG supply valve was switched, and supply of the raw material to the reaction furnace was halted, thereby halting the deposition of the GaN layer. Subsequently, power supply to the heater was halted, and the temperature of the substrate was lowered to room temperature.
By following the above procedure, a base layer 14a formed of an undoped GaN with a thickness of 2 µm was formed on the buffer layer 12 formed of a single crystal structure AlN provided on top of the substrate 11. Upon removal from the reaction furnace, the sample had a colorless and transparent appearance, and the surface of the GaN layer (base layer 14a) had a mirror-like appearance.

The X-ray rocking curve (XRC) for the base layer 14a composed of an undoped GaN formed as described above was then measured using an X-ray measurement apparatus (model: X'part Pro MRD, manufactured by Spectris plc). The measurements were conducted using a Cuβ X-ray beam generation source as the X-ray source, and were conducted for the symmetrical (0002) plane and the asymmetrical (10-10) plane. Generally, in the case of a Group III nitride compound semiconductor, the full width at half maximum in the XRC spectrum of the (0002) plane acts as an indicator of the crystal smoothness (mosaicity), whereas the full width at half maximum in the XRC spectrum of the (10-10) plane acts as an indicator of the dislocation density (twist). The measurement results revealed that for the undoped GaN layer manufactured using the manufacturing method of the present invention, the full width at half maximum value was 46 arcsec in the measurement of the (0002) plane and 220 arcsec in the measurement of the (10-10) plane.

### "Formation of n-Type Contact Layer"

Next, the substrate 11 having the base layer 14a formed thereon was transported into the MOCVD apparatus, and an n-type contact layer was formed by means of a MOCVD method. At this time, the n-type contact layer was doped with Si. As the MOCVD apparatus used for forming GaN here, a conventionally known apparatus was used.

Using the types of procedures described above, the surface of a substrate 11 formed of sapphire was subjected to reverse sputtering, a buffer layer 12 formed of AlN having a single crystal structure was formed on the substrate 11, and an undoped GaN layer (n-type base layer 14a) with a film thickness of 2 µm and a Si-doped GaN layer (n-type contact layer 14b) with a film thickness of 2 µm and having a carrier concentration of 5 × 10¹⁸ cm³ were then formed on the buffer layer 12. Following film formation, the substrate removed from the apparatus was colorless and transparent, and the surface of the GaN layer (here, the n-type contact layer 14b) was a mirror-like surface.

### "Formation of n-Type Cladding Layer and Light-Emitting Layer"

On the sample n-type contact layer manufactured using the above procedures, there were laminated, by means of a MOCVD method, an n-type cladding layer 14c and a light-emitting layer 15.

### 'Formation of n-Type Cladding Layer'

First, the substrate having the n-type contact layer composed of Si-doped GaN deposited thereon was transported into the chamber of an MOCVD apparatus. Then, the temperature of the substrate was raised to 1000°C in a state where the inside of the chamber had been replaced with nitrogen, and the contamination adhered on the top most surface of the n-type contact layer was sublimated and thereby removed. At this time, ammonia was supplied into the furnace from the point of time where the substrate temperature had become 830°C or higher.

Subsequently, having lowered the temperature of the substrate to 740°C, an SiH₄ gas, TMI generated by bubbling, and vapors of TEG were supplied into the furnace while the supply of ammonia into the chamber was continued, to thereby form an n-type cladding layer 14c composed of Si-doped In_{0.01}Ga_{0.99}N and having a film thickness of 180 Å. The valves of TMI, TEG, and SiH4 were then switched and supplies of these raw materials were halted.

### 'Formation of Light-Emitting Layer'

Next, there was formed a light-emitting layer 15 that was composed of a barrier layer 15a formed of GaN and a well layer 15b formed of In_{0.2}Ga_{0.8}N and that had a multiple quantum well structure. In order to form this light-emitting layer 15, the barrier layer 15a was first formed on the n-type cladding layer 14c formed of Si-doped In_{0.01}Ga_{0.99}N, and the well layer 15b formed of In_{0.2}Ga_{0.8}N was then formed on top of this barrier layer 15a. This type of lamination procedure was repeated five times, and a sixth barrier layer 15a was then formed on top of the fifth laminated well layer 15b, thereby forming a structure in which a barrier layer 15a was positioned at both sides of the light-emitting layer 15 having a multiple quantum well structure.

That is to say, following formation of the n-type cladding layer 14c formed of Si-doped In_{0.01}Ga_{0.99}N, the valve of TEG was switched so as to supply TEG into the furnace while the substrate temperature, the pressure within the furnace, and the flow rate and type of the carrier gas were kept unchanged, and thereby the barrier layer 15a composed of GaN was formed. Thereby, the barrier layer 15a having a film thickness of 150 Å was formed.

Next, having completed formation of the barrier layer 15a, the valves of TEG and TMI were switched so as to supply TEG and TMI into the furnace while the temperature of the substrate 11, the pressure within the furnace, and the flow rate and type of the carrier gas were kept unchanged, and thereby the well layer 15b composed of In_{0.2}Ga_{0.8}N were formed. Thereby, the barrier layer 15b having a film thickness of 20 Å was formed.

Having completed formation of the well layer 15b, a barrier layer 15a was again formed. By repeating this type of procedure five times, five barrier layers 15a and five well layers 15b were formed. Further, a barrier layer 15a was formed on the last laminated well layer 15b, thereby providing the light-emitting layer 15.

### "Formation of p-Type Semiconductor Layer"

The p-type semiconductor layer 16 was formed on the wafer that had been obtained in the respective treatment processes described above, using an MOCVD apparatus.
As the MOCVD apparatus used for forming the p-type semiconductor layer 16 here, a conventionally known apparatus was used. Moreover, at this time, the p-type semiconductor layer 16 was doped with Mg.

Finally, there was formed the p-type semiconductor layer 16 formed with a p-type cladding layer 16a having a film thickness of 10 nm and composed of Mg-doped Al_{0.1}Ga_{0.9}N, and a p-type contact layer 16b having a film thickness of 200 nm and composed of Mg-doped Al_{0.02}Ga_{0.98}N.

The epitaxial wafer for an LED prepared in the manner described above has a laminated structure in which, as with the laminated semiconductor layer 10 shown in FIG. 1, an AIN layer (the buffer layer 12) having a single crystal structure is first formed on a substrate 11 composed of sapphire having a c-plane, and sequentially thereafter are formed, from the substrate 11 side, a 2 µm undoped GaN layer (the base layer 14a), an Si-doped GaN layer (the n-type contact layer 14b) of 2 µm having an electron concentration of 5 × 10¹⁸ cm⁻³, an In_{0.01}Ga_{0.99}N cladding layer (the n-type cladding layer 14c) of 180 Å having an electron concentration of 1 × 10¹⁸ cm⁻³, a multiple quantum well structure (the light-emitting layer 15) that begins with a GaN barrier layer and ends with a GaN barrier layer, and is composed of six GaN barrier layers (the barrier layers 15a) each having a layer thickness of 150 Å and five undoped In_{0.2}Ga_{0.8}N well layers (the well layers 15b) each having a layer thickness of 20 Å, and an Mg-doped AlGaN layer (the p-type semiconductor layer 16) composed of a p-type cladding layer 16a with a thickness of 10 nm formed of Mg-doped Al_{0.1}Ga_{0.9}N and a p-type contact layer 16b with a thickness of 200 nm formed of Mg-doped Al_{0.02}Ga_{0.98}N.

### "Manufacturing of LED"

Next, an LED was manufactured using the above-mentioned epitaxial wafer (the laminated semiconductor 10).
That is to say, a conventional photolithography technique was used to form a translucent electrode 17 composed of ITO on the surface of the Mg-doped AIGaN layer (the p-type contact layer 16b) of the epitaxial wafer, and a positive electrode bonding pad 18 (a p-electrode bonding pad) was formed by sequentially laminating titanium, aluminum, and gold onto the translucent electrode 17, thus completing a p-side electrode. Furthermore, the wafer was then subjected to dry etching to expose a region of the n-type contact layer 14b for forming an n-side electrode (a negative electrode), and the negative electrode 19 (the n-side electrode) was then formed by sequentially laminating four layers, namely Ni, Al, Ti and Au, onto this exposed region 14d. Using this procedure, the respective electrodes having the shapes shown in FIG. 2 were formed on the wafer (refer to the laminated semiconductor 10 in FIG. 1).

The underside of the sapphire substrate 11 within the wafer comprising the respective p-side and n-side electrodes formed via the procedure outlined above was then ground and polished to form a mirror-like surface. The wafer was then cut into square chips having a side length of 350 µm. The chip was then positioned on a lead frame with each electrode facing upwards, and gold wiring was used to connect the electrodes to the lead frame, thus forming a light-emitting diode (refer to the lamp 3 in FIG. 4).
When a forward current was caused to flow between the p-side and n-side electrodes of the thus prepared light-emitting diode, the forward voltage at a current of 20 mA was 3.1 V. Further, when the state of light emission was observed through the p-side translucent electrode 17, the light emission wavelength was 460 nm and the light emission output was 15.2 mW. In the produced light-emitting diodes, these types of light emission properties were obtained with minimal variation across almost the entire surface of the manufactured wafer.

### [Example 2]

Using the same procedure as Example 1 above with the exception of using conditions where the crystal structure of a buffer layer to be formed on the substrate becomes a polycrystalline structure formed of a columnar crystal aggregate, the buffer layer was laminated on the substrate, an undoped GaN layer (a base layer) was laminated thereon, and respective layers composed of Group III nitride semiconductors were further formed, thereby producing a light-emitting device shown in FIG. 2 and FIG. 3.

When the X-ray rocking curve (XRC) of the buffer layer formed on the substrate was measured using the same method as Example 1, the XRC full width at half maximum was 12 arcsec. Moreover, the composition of the buffer layer was measured using an X-ray photoelectron spectroscopy apparatus (XPS), and as with Example 1, the measurement result confirmed that the oxygen concentration was 1 atomic percent or lower.

Using the same method as Example 1, a GaN layer was formed on the buffer layer formed on the substrate by means of a reactive sputtering method. Upon removal from the chamber, the substrate had a colorless and transparent appearance, and the surface of the GaN layer had a mirror-like appearance.
When the X-ray rocking curve (XRC) of the base layer composed of undoped GaN that had been formed as described above was measured using the same method as Example 1, the full width at half maximum value was 93 arcsec in the measurement of the (0002) plane and 231 arcsec in the measurement of the (10-10) plane.

The respective layers composed of Group III nitride semiconductors were formed on the base layer using the same method as Example 1, and having formed the translucent electrode, the positive electrode bonding pad, and the respective electrodes of the negative electrode on this wafer, the underside of the substrate was ground and polished to form a mirror-like surface. Then, the substrate was cut into square chips having a side length of 350 µm, and gold wiring was used to connect the respective electrodes to the lead frame, thus forming a light-emitting device illustrated as the lamp 3 in FIG. 4.
When a forward current was caused to flow between the p-side and n-side electrodes of the thus prepared light-emitting diode, the forward voltage at a current of 20 mA was 3.1 V. Further, when the state of light emission was observed through the p-side translucent electrode 17, the light emission wavelength was 460 nm and the light emission output was 15.2 mW. In the produced light-emitting diodes, these types of light emission properties were obtained with minimal variation across almost the entire surface of the manufactured wafer.

### [Comparative Example]

After conducting a pretreatment on the substrate, dummy discharging was not performed when suctioning inside the chamber using a vacuum pump to remove impurities, and the ultimate vacuum was 1.0 × 10⁻³ Pa. With the exception of this, using the same procedure as the above Example 1, a buffer layer was laminated on the substrate, an undoped GaN layer (a base layer) was laminated thereon, and then respective layers composed of Group III nitride semiconductors were further formed, thereby producing a light-emitting device shown in FIG. 2 and FIG. 3.

When the X-ray rocking curve (XRC) of the buffer layer formed on the substrate was measured using the same method as Example 1, the XRC full width at half maximum was 50 arcsec. Moreover, the composition of the buffer layer was measured using an X-ray photoelectron spectroscopy apparatus (XPS), and as shown in FIG. 6B, the measurement result revealed that the oxygen concentration was 5 atomic percent or lower during the etching time from 3 minutes to 10 minutes that corresponding to the buffer layer.

Using the same method as Example 1, a GaN layer was formed on the buffer layer formed on the substrate by means of a reactive sputtering method. Upon removal from the chamber, the substrate had a colorless and transparent appearance, and the surface of the GaN layer had a mirror-like appearance.
When the X-ray rocking curve (XRC) of the base layer composed of undoped GaN that had been formed as described above was measured using the same method as Example 1, the full width at half maximum value was 200 arcsec in the measurement of the (0002) plane and 374 arcsec in the measurement of the (10-10) plane.

The respective layers composed of Group III nitride semiconductors were formed on the base layer using the same method as Example 1, and having formed the translucent electrode, the positive electrode bonding pad, and the respective electrodes of the negative electrode on this wafer, the underside of the substrate was ground and polished to form a mirror-like surface. Then, the substrate was cut into square chips having a side length of 350 µm, and gold wiring was used to connect the respective electrodes to the lead frame, thus forming a light-emitting device (refer to FIG. 4).
When a forward current was caused to flow between the p-side and n-side electrodes of the thus prepared light-emitting diode, the forward voltage at a current of 20 mA was 3.05 V. Further, when the state of light emission was observed through the p-side translucent electrode 17, the light emission wavelength was 460 nm and the light emission output was 14.3 mW.

### [Experimental Example]

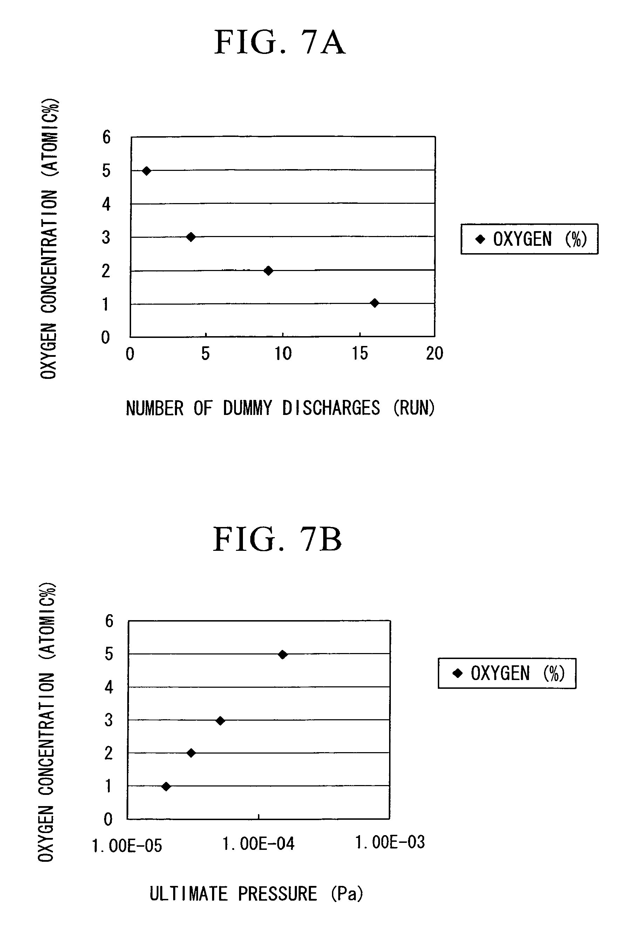

Hereunder, there is described, with reference to the respective graphs in FIG. 7A and FIG. 7B, an experimental example for substantiating the present invention. FIG. 7A is a graph showing a relationship between the number of dummy discharges and oxygen concentration in the buffer layer, and FIG. 7B is a graph showing a relationship between ultimate vacuum within the chamber and oxygen concentration within the buffer layer.
In the present experimental example, after conducting a pretreatment on the substrate, dummy discharging was performed the number of times shown in FIG. 7A when removing impurities by suctioning inside the chamber using a vacuum pump, and the ultimate vacuum was set to conditions shown in FIG. 7B (No. 1 = 2.0 × 10⁻⁵ Pa, No. 2 = 3.1 × 10⁻⁵ Pa, No. 3 = 5.1 × 10⁻⁵ Pa, No. 4 = 1.5 × 10⁻⁴ Pa). With the exception of this, the same method as Example 1 was used to manufacture respective samples No. 1 to 4 comprising a buffer layer formed on the substrate.

When the X-ray rocking curve (XRC) of the buffer layer formed on the substrate was measured for the respective samples No. 1 to 4 using the same method as Example 1, the XRC full widths at half maximum were No. 1: 10 arcsec, No. 2: 12 arcsec, No. 3: 33 arcsec, and No. 4: 39 arcsec. Moreover, when the composition of the buffer layer of each of the samples No. 1 to 4 was measured using an XPS, as shown in the graph of FIG. 7B, the measurement result confirmed that the oxygen concentration of the sample No. 1, the buffer layer of which had been formed under a condition where the ultimate vacuum was 2.0 × 10⁻⁵ Pa, was 1%. In contrast, it was confirmed that the oxygen concentration in the buffer layer of all of the samples No. 2 to 4, the ultimate vacuum condition of which were respectively 3.1 × 10⁻⁵ Pa, 5.1 × 10⁻⁵ Pa, and 1.5 × 10⁻⁴ Pa, was 2% or higher, and was higher than the oxygen concentration of the sample No. 1.

The above results revealed that when removing impurities by suctioning inside the chamber using a vacuum pump, by conducting dummy discharging approximately 16 times (runs), the ultimate vacuum within the chamber reaches 2.0 × 10⁻⁵ Pa, and it is accordingly possible to suppress the oxygen concentration at 1% or lower in the buffer layer formed on the substrate.

From the above results, it is clear that the Group III nitride semiconductor light-emitting device according to the present invention has superior productivity and also a superior light emission property.

### INDUSTRIAL APPLICABILITY

The present invention relates to a Group III nitride semiconductor light-emitting device that is formed by sequentially laminating, on a sapphire substrate, a buffer layer, an n-type semiconductor layer, a light-emitting layer, and a p-type semiconductor layer. The semiconductor light-emitting device of the present invention is such that the buffer layer thereof contains oxygen, however, the oxygen concentration in the buffer layer is 1 atomic percent or lower, and a Group III nitride semiconductor having favorable crystallinity can be formed thereon. Therefore, the semiconductor light-emitting device has a superior light emission property. This Group III nitride semiconductor light-emitting device having a superior light emission property can be applied to a lamp.

## Claims

1. A Group III nitride semiconductor light-emitting device formed such that a buffer layer composed of at least a Group III nitride compound is laminated on a substrate composed of sapphire, and an n-type semiconductor layer, a light-emitting layer, and a p-type semiconductor layer are sequentially laminated on the buffer layer, wherein
said buffer layer is formed by means of a reactive sputtering method, said buffer layer contains oxygen, and an oxygen concentration in the buffer layer is 1 atomic percent or lower.

2. A Group III nitride semiconductor light-emitting device according to claim 1, wherein said buffer layer is formed by means of a reactive sputtering method, in which a metallic Al material and a gas containing a nitrogen element are activated with plasma, and said buffer layer is comprised of A1N.

3. A Group III nitride semiconductor light-emitting device according to either one of claim 1 and claim 2, wherein the oxygen concentration in said buffer layer is 0.8 atomic percent or lower.

4. A Group III nitride semiconductor light-emitting device according to any one of claim 1 through claim 3, wherein the oxygen contained in said buffer layer is distributed within the buffer layer film at a substantially uniform oxygen concentration.

5. A Group III nitride semiconductor light-emitting device according to any one of claim 1 through claim 4, wherein the film thickness of said buffer layer is within a range from 10 to 500 nm.

6. A Group III nitride semiconductor light-emitting device according to any one of claim 1 through claim 4, wherein the film thickness of said buffer layer is within a range from 20 to 100 nm.

7. A Group III nitride semiconductor light-emitting device according to any one of claim 1 through claim 6, wherein said buffer layer is formed so as to cover at least 90% of said substrate surface.

8. A method for manufacturing a Group III nitride semiconductor light-emitting device in which a buffer layer composed of at least a Group III nitride compound is laminated on a substrate composed of sapphire, and an n-type semiconductor layer, a light-emitting layer, and a p-type semiconductor layer are sequentially laminated on the buffer layer, wherein
said buffer layer is formed by means of a reactive sputtering method such that said buffer layer contains oxygen and an oxygen concentration in the buffer layer is 1 atomic percent or lower.

9. A method for manufacturing a Group III nitride semiconductor light-emitting device according to claim 8, wherein said buffer layer is formed by means of a reactive sputtering method, in which a metallic Al material and a gas containing a nitrogen element are activated with plasma, and it is formed with AlN.

10. A method for manufacturing a Group III nitride semiconductor light-emitting device according to either one of claim 8 and claim 9, wherein said buffer layer is formed under a condition where the ultimate vacuum within the chamber of a sputtering apparatus is 1.5 × 10⁻⁵ Pa or lower.

11. A method for manufacturing a Group III nitride semiconductor light-emitting device according to any one of claim 8 through claim 10, wherein said buffer layer is formed after performing dummy discharging within the chamber of said sputtering apparatus.

12. A method for manufacturing a Group III nitride semiconductor light-emitting device according to any one of claim 8 through claim 11, wherein said buffer layer is formed by means of a reactive sputtering method in which said gas containing a nitrogen element is supplied within a reactor.

13. A method for manufacturing a Group III nitride semiconductor light-emitting device according to any one of claim 8 through claim 12, wherein said buffer layer is formed by means of a RF sputtering method.

14. A method for manufacturing a Group III nitride semiconductor light-emitting device according to any one of claim 8 through claim 13, wherein said buffer layer is formed where the temperature of said substrate is within a range from 400 to 800°C.

15. A Group III nitride semiconductor light-emitting device that is obtained by a manufacturing method according to any one of claim 8 through claim 14.

16. A lamp that uses a Group III nitride semiconductor light-emitting device according to any one of claim 1 through claim 7, and claim 15.
